# EUROPÄISCHE PATENTSCHRIFT

(11) **EP 0 506 690 B1**
(45) Veröffentlichungstag und Bekanntmachung des Hinweises auf die Patenterteilung: **28.06.1995**
(21) Anmeldenummer: 91900156.0
(22) Anmeldetag: 19.12.1990
(51) Int. Cl.: C30B 31/10, C30B 31/20, C30B 35/00, H01L 21/00, G21C 1/30

(54) **TRANSPORTSYSTEM, INSBESONDERE ZUM TRANSPORTIEREN VON SILIZIUM EINKRISTALLEN DURCH DAS BECKEN EINES FORSCHUNGSREAKTORS.**
TRANSPORT SYSTEM, IN PARTICULAR FOR TRANSPORTING SILICON MONOCRYSTALS THROUGH THE TANK OF A RESEARCH REACTOR
SYSTEME DE TRANSPORT, EN PARTICULIER POUR LE TRANSPORT DE MONOCRISTAUX DE SILICIUM A TRAVERS LA CUVE D'UN REACTEUR DE RECHERCHE

(30) Priorität: 21.12.1989 DE 3942387
(43) Veröffentlichungstag der Anmeldung: 07.10.1992
(73) Patentinhaber: FISCHER, Florian, D-85560 Ebersberg (DE)
(72) Erfinder: FISCHER, Florian, D-85560 Ebersberg (DE)
(74) Vertreter: Haft, von Puttkamer, Berngruber, Czybulka
(86) Internationale Anmeldenummer: DE9000976
(87) Internationale Veröffentlichungsnummer: WO9109996

(56) Entgegenhaltungen:
- DE-A- 2 438 710
- GB-A- 2 162 504

## Beschreibung

Die Erfindung bezieht sich auf ein Transportsystem gemäß dem Oberbegriff des Patentanspruches 1.

Ein solches Transportsystem wird z.B. in Forschungsreaktoren verwendet, in denen Siliziumeinkristalle durch Neutronenbeschuß mit Phosphor dotiert werden. Die Siliziumkristalle sind hierbei in Behältern angeordnet, die längs und innerhalb eines vertikal angeordneten, den Schwerwassertank des Reaktorbeckens durchgreifenden Rohres transportiert werden. Um eine möglichst gleichmäßige Bestrahlung zu erhalten, werden dabei die Behälter auch um die Rohrachse gedreht. Dies erfolgt z.B. dadurch, daß ein Behälter an einer langen Stange befestigt ist und mit Hilfe dieser durch das Rohr geschoben und dabei gedreht wird.

Derartige Transportsysteme können des weiteren z.B. in Bioreaktoren oder in Galvanisieranlagen eingesetzt werden. Bei allen Einsatzmöglichkeiten ist aufgrund der meist beengten Platzverhältnisse auf eine möglichst schmalbauende Konstruktion zu achten. Insbesondere erfordert die aggressive Umgebung, die teilweise bedingt ist durch den Behandlungszweck, so z.B. Radioaktivität oder aggressive Flüssigkeiten, eine sensible Auswahl der verwendeten Materialien sowie eine möglichst einfache wartungsfreundliche und langlebige Konstruktion.

Bei dem oben erwähnten Dotieren von Halbleiterkristallen in einem Reaktor sollte zusätzlich noch die Möglichkeit bestehen, dieses Dotieren möglichst gleichmäßig und kontinuierlich erfolgen zu lassen, d.h. daß jeder durch den Reaktor geschickte Behälter etwa den gleichen Bestrahlungszuständen ausgesetzt ist, und daß trotzdem eine hohe Förderkapazität erreicht wird.

Der Erfindung liegt die Aufgabe zugrunde, ein Transportsystem der in Rede stehenden Art so auszugestalten, daß bei einen einfachen Konstruktion eine hohe Förderkapazität erreicht wird, und daß das Transportsystem auch in aggressiven Umgebungen eingesetzt werden kann.

Diese Aufgabe ist gemäß der Erfindung durch die kennzeichnenden Merkmale des Patentanspruches 1 gelöst.

Demgemäß besteht das Transportsystem aus drei Einheiten, nämlich einem Drehrohr, einer Gewindehülse und den in dem Drehrohr und der Gewindehülse transportierten Behältern. Das Drehrohr, in dem die Behälter drehfest gehalten sind, übernimmt die Drehbewegung der Behälter, während für den Transport der Behälter längs der Rohrachse die Gewindehülse verantwortlich ist. Ein sich in der Gewindehülse befindender Behälter greift mit seinen Gleitern in die Gewindezüge der Gewindehülse ein und wird in diese eingeschraubt, da durch Kupplungen zwischen den Behältern die Drehbewegung des Drehrohres übertragen wird. Nach dem Durchgang des jeweiligen Behälters durch die Gewindehülse wird dieser von einer Übernahmevorrichtung übernommen und gegebenenfalls weitertransportiert.

Wenn mit diesem Transportsystem Behälter mit Siliziumkristallen durch den Schwerwassertank eines Reaktors transportiert werden sollen, so sind das Drehrohr und die Gewindehülse in einem Durchgangsrohr durch den Schwerwassertank angeordnet. Die Drehhülse kann an einem Absatz des Durchgangsrohres drehfest angeordnet sein, wobei es jedoch aus Sicherheitsgründen günstiger ist, eine Abstützung der Drehhülse an ihrer Unterseite zu verwenden, die vom Boden des Reaktorbeckens ausgeht.

Das beschriebene Transportsystem ermöglicht einen kontinuierlichen Transport eines Zuges von Behältern längs des Drehrohrs und der Gewindehülse. Bei der Bestrahlung von Siliziumeinkristallen in einem Reaktor ist damit gewährleistet, daß alle Kristalle kontinuierlich und in gleicher Weise bestrahlt werden.

Für andere Anwendungsfälle ist es nicht notwendig, daß die Rohre und Behälter aus Vollmaterial sind; so ist es z.B. für einen Transport von Gütern durch Galvanisierbäder notwendig, die einzelnen Komponenten des Fördersystems aus Netzmaterial auszugestalten, so daß die Galvanisierflüssigkeit auch in das Innere der Behälter gelangt. Ebenso ist es möglich, ein zu transportierendes Gut direkt in dem Drehrohr zu führen, solange Vorsorge dafür getroffen ist, daß dieses Gut mit Kupplungen und entsprechenden Gleitern ausgerüstet sind, die in die Führungseinrichtungen des Drehrohres eingreifen.

Weitere Ausgestaltungen der Erfindung gehen aus den Unteransprüchen hervor.

Die Erfindung ist in einem Ausführungsbeispiel anhand der Zeichnung näher erläutert. In dieser stellen dar:
- Fig. 1: einen schematischen Querschnitt durch einen Forschungsreaktor, in dem ein Transportsystem gemäß der Erfindung angeordnet ist, wobei mit diesem Transportsystem in Behältern enthaltene Siliziumeinkristalle längs eines vertikalen Drehrohres durch den Schwerwassertank eines Forschungsreaktors transportiert werden;
- Fig. 2: eine detailliertere Darstellung des Transportsystems im Bereich des Schwerwassertankes;
- Fig. 3: einen Schnitt längs III-III in Fig. 2;
- Fig. 4: einen teilweise weggebrochenen Schnitt längs IV-IV in Fig. 2;
- Fig. 5: einen Längsschnitt durch einen - hier modifizierten - Behälter für ein Transportsystem gemäß der Erfindung;
- Fig. 6: eine Aufsicht auf die Ober- bzw. Unterseite eines Behälters für das Transportsystem.

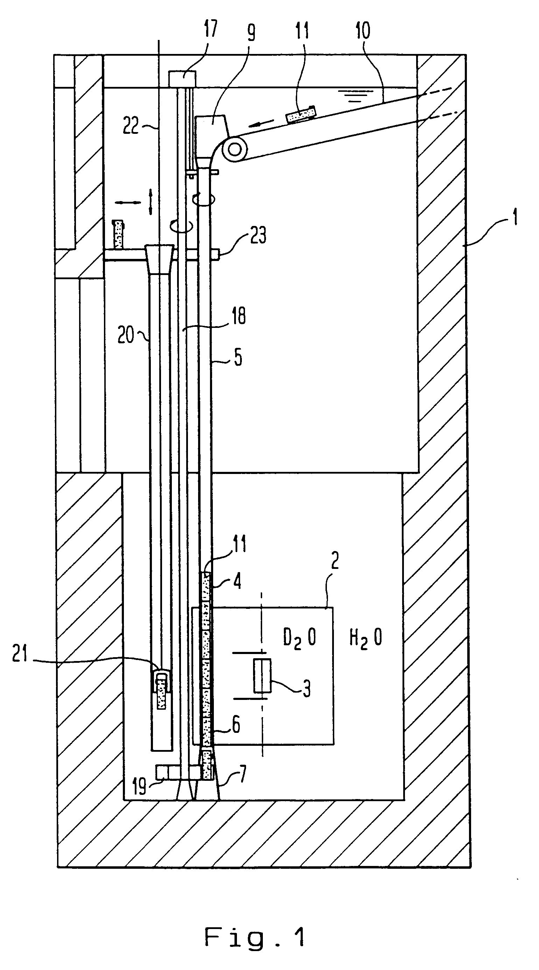

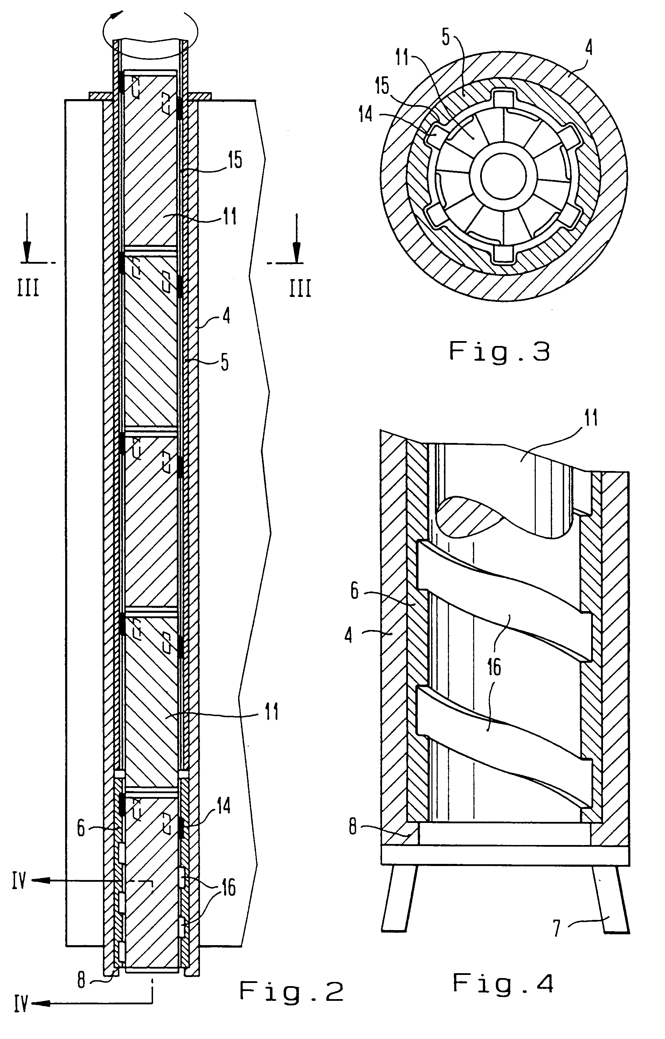

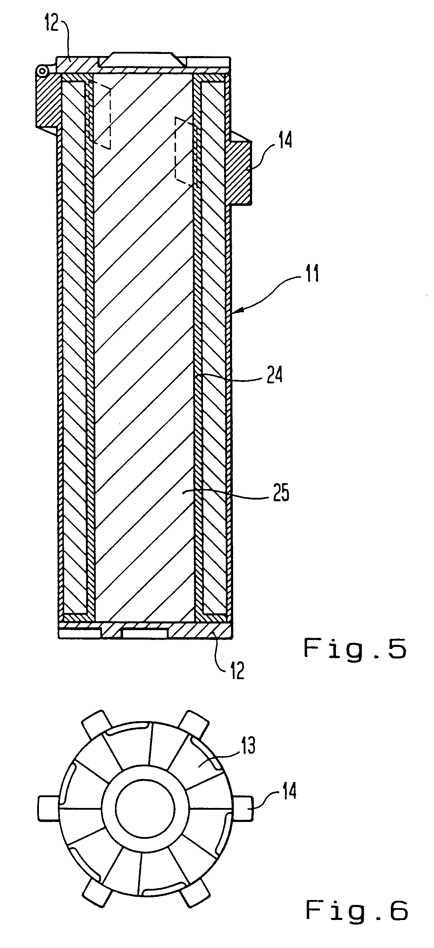

In einem mit Wasser gefüllten Reaktorbecken 1 ist im Bereich des Bodens ein Schwerwassertank 2 angeordnet, in dem sich schweres Wasser und im Zentrum der Kern 3 des Reaktors befinden. Durch den Schwerwassertank 3 verläuft am Rand ein gegenüber dem Tank abgedichtetes vertikales Durchgangsrohr 4, in das von oben ein Drehrohr 5 eingreift und in dem am unteren Ende eine Gewindehülse 6 angeordnet ist. Drehrohr 5 und Gewindehülse 6 sind koaxial und weisen einen Außendurchmesser auf, der etwa dem Innendurchmesser des Durchgangsrohres 4 entspricht. Die Gewindehülse 6 ist drehfest in dem Durchgangsrohr 4 angeordnet und, wie in Fig. 4 gezeigt, mit einer bis zum Boden des Reaktorbeckens reichenden Stützkonstruktion gehalten. Zusätzlich kann die Gewindehülse noch durch einen Bodenflansch 8 des Durchgangrohres 4 abgestützt sein. Das Drehrohr 5 reicht bis knapp unterhalb der Wasseroberfläche und weist an seinem oberen Ende einen Führungstrichter 9 auf, an den sich ein schräg nach oben aus dem Reaktorbecken laufendes Förderband 10 anschließt, über das Behälter 11 transportiert und über den Führungstrichter 9 in das Drehrohr eingebracht werden können. Die Behälter 11 sind zylinderförmige Dosen mit jeweils einem Deckel 12 an der Oberseite, wobei Boden und Deckel, wie in Fig. 6 gezeigt, mit einer Stirnverzahnung 13 versehen sind, d.h. mit jeweils höher bzw. niedriger gelegenen flächigen Segmenten. Wenn zwei Behälter, wie in den Fig. 1 und 2 gezeigt, aneinander liegen, so greifen diese Stirnverzahnungen ineinander ein und halten die beiden Behälter 11 drehfest zueinander. Um den Umfang verteilt, und in diesem Falle im oberen Bereich, weist jeder Behälter eine Anzahl von in diesem Falle sechs Nasen 14 auf, die in entsprechende Führungsnuten 15 des Drehrohres 5 eingreifen, wobei diese Führungsnuten 15 in Längsrichtung des Drehrohres verlaufen. Die Nasen 14 sind am Umfang des Behälters längs eines Gewindeganges angeordnet, der die gleiche Steigung wie eine Gewindenut 16 aufweist, die in der Innenwand der Gewindehülse 6 vorgesehen ist; vgl. Fig. 4.

Für das Drehrohr 5 ist am oberen Rand des Reaktorbeckens 1 ein Drehantrieb 17 vorgesehen, mit dem das Rohr um seine Rohrachse kontinuierlich gedreht werden kann. Von dem Drehantrieb geht auch eine parallel zu dem Drehrohr verlaufende Schaltstange aus, die zu einem Übergabekarussell 19 führt, das unterhalb der Gewindehülse 6 gelegen ist. Auf der dem Drehrohr 5 abgewandten Seite der Schaltstange 18 ist ein Führungsrohr 20 gelegen, in dem ein Greifer 21 mit Hilfe eines Greiferseiles 22 verfahren werden kann. Das Führungsrohr 20 endet noch innerhalb des Reaktorbeckens im Bereich einer Abstützplattform 23.

Die Funktion des beschriebenen Transportsystems ist folgende:
Über das Förderband 10 werden durch den Fördertrichter 9 mehrere Behälter eingebracht, wobei darauf geachtet werden muß, daß beim Einbringen in das Drehrohr sämtliche Behälter jeweils die gleiche Drehorientierung aufweisen. Die Behälter sinken längs der Führungsnuten 15 im Drehrohr 5 ab und werden hierbei gebremst, da das vor ihnen liegende Wasser durch den Spalt zwischen Drehrohr und der Behälteraußenwand verdrängt werden muß. Es sei angenommen, daß wie in den Fig. 1 und 2 gezeigt sich im Bereich des Durchgangsrohres 4 fünf Behälter 11 befinden, wovon einer bereits in der Gewindehülse eingetaucht ist. Man sieht, daß die Nasen 14 dieses Behälters bereits in die Gewindenut 16 eingreifen. Durch die Drehung des Drehrohres 5, bei der die in dem Drehrohr befindlichen Behälter 11 dank des Eingriffes der Nasen 14 in die Führungsnuten 15 mitgenommen werden, und durch die Übertragung dieser Drehbewegung dank der Stirnverzahnung 13 wird der sich in der Gewindehülse 6 befindliche Behälter 11 durch die Gewindehülse hindurchgeschraubt, wobei die sich darüber befindlichen Behälter dank ihres Gewichtes nachsinken.

Ist der unterste Behälter 11 durch die Gewindehülse 6 hindurchgeschraubt, so wird er von dem Übergabekarussell 19 übernommen, mit Hilfe der Schaltstange unter das Führungsrohr 20 gefahren, dort mit dem Greifer 21 ergriffen und auf die Abstützplattform 23 hochgezogen und dort abgestellt. In dieser Stellung kann der Behälter samt Inhalt, in diesem Falle Siliziumeinkristallen etwa drei Tage abklingen.

Sobald der sich jeweilig in der Gewindehülse 6 befindliche Behälter diese verläßt, greifen die Nasen 14 des darüberliegenden Behälters in den Gewindezug 16, so daß auch dieser Behälter durch die Gewindehülse geschraubt wird. Auf diese Weise erhält man einen kontinuierlichen Transport sämtlicher Behälter durch den Schwerwassertank, wobei die Behälter auch noch gleichmäßig gedreht werden. Die Transportdauer jedes Behälters durch den etwa 2,5 Meter hohen Schwerwassertank soll etwa drei Stunden betragen. Hieraus resultieren entsprechend die Drehzahl des Drehrohres und dann die Steigung der Gewindenut 16. Das Gewinde ist hierbei selbsthemmend ausgelegt. Erfolgt daher keine Zwangsförderung durch die Drehung des Gewinderohres 5, so verharren die Behälter 11 in der jeweiligen Lage. Am Schluß des Prozesses wird das Drehrohr mit Behältern 11 aufgefüllt, in die ein Moderator, z.B. Graphit oder Beryllium eingesetzt ist, damit in das Durchgangsrohr nur wenig leichtes Wasser eindringt.

In den zylindrischen Behältern 11 sind zylindrische Siliziumeinkristalle mit einer Länge von 50 Zentimetern und einem Durchmesser von etwa 15 Zentimeter aufgenommen, die den Innenraum der Behälter satt ausfüllen. Es ist jedoch auch möglich, in den Innenraum im Radius kleinere Siliziumkristalle oder andere Güter aufzunehmen. Hierfür kann in dem Behälter 11, wie in Fig. 5 gezeigt, ein Einsatz 24 eingesetzt werden, der dann einen kleineren Siliziumeinkristall 25 aufnimmt.

Sämtliche Teile des beschriebenen Fördersystems sind aus Materialien gefertigt, die nach der Bestrahlung beim Durchgang durch den Schwerwassertank rasch wieder abklingen. Hierzu eignet sich bevorzugt Aluminium; möglich wäre Beryllium, das jedoch wegen der toxischen Wirkung des Berylliumstaubes nur in Ausnahmefällen eingesetzt werden sollte.

Sämtliche Komponenten des beschriebenen Transportsystemens, insbesondere die der Strahlung im Schwerwassertank ausgesetzten, können aus einem einzigen Werkstoff hergestellt werden, vorzugsweise aus Aluminium, wobei Gleitlagerflächen anodisch hart oxidiert werden sollten. Bei dem Betriebssystem ist eine Montage der Verschleißkomponenten, insbesondere von Drehrohr und Gewindehülse auch während des Reaktorbetriebes möglich, so daß diese Teile auch ausgewechselt werden können.

Modifikationen des beschriebenen Transportsystems sind selbstverständlich möglich: So könnte z.B. die Gewindehülse eine Länge aufweisen, die über mehr als einen Behälter hinausreicht; außerdem könnte statt der eingängigen Gewindenut in dem Führungsbehälter ein mehrgängiges Gewinde vorgesehen sein; in diesem Falle wäre es sogar möglich, die Nasen 14 nicht längs eines Schraubenganges, sondern alle auf gleicher Höhe längs eines Kreises am Umfang des Behälters.

Ferner wäre es möglich, die Drehübertragung von Behälter zu Behälter außer durch Formschluß auch durch Reibschluß zu sichern.

Obwohl im vorhergehenden die Gewindegänge an der Innenwand der Gewindehülse und die in die Gewindegänge eingreifenden Gegenstücke als Greifer an den Außenwänden der Behälter eingerichtet sind, ist selbstverständlich auch eine umgekehrte Lösung denkbar, so daß die Behälter ein Außengewinde und die Gewindehülse entsprechende Gleiter aufweist. Ebenso wären dann die Führungseinrichtungen innerhalb des Drehrohres entsprechend umgekehrt eingerichtet.

## Patentansprüche

1. Vorrichtung bestehend aus einem Transportsystem und zugeordneten Behältern zum Transportieren der Behälter innerhalb und längs eines im wesentlichen vertikal angeordneten Rohres unter gleichzeitigem Drehen der Behälter um die Rohrachse, insbesondere zum Transportieren von Halbleitereinkristalle aufnehmenden Behältern durch ein Reaktorbecken zum Dotieren der Einkristalle, gekennzeichnet durch folgende Merkmale:
das Rohr (5) ist um seine Rohrachse drehbar (Drehrohr 5);
zwischen Rohr (5) und Behälter (11) sind Führungseinrichtungen (14, 15) vorgesehen, die die Behälter (11) beim Transport längs des Drehrohres (5) gegenüber diesem drehfest halten;
direkt anschließend an das Drehrohr (5), am Ende der Transportstrecke, ist eine nicht mit dem Drehrohr (5) verbundene, jedoch zu diesem koaxiale, drehfest gehaltene und an beiden Seiten offene Hülse (6) vorgesehen;
zwischen Hülse (6) und Behältern (11) ist eine Gewindeeinrichtung (14, 16) vorgesehen, mittels der die Behälter (11) längs der Hülse (6) transportiert werden;
die Behälter (11) weisen an ihrer Ober- und Unterseite jeweils Kupplungen (13) auf, die beim Transport eines Zuges von aneinanderliegenden Behältern (11) in die Kupplungen des vorauslaufenden und des nachfolgenden Behälters eingreifen, wobei die Kupplungen (13) so ausgestaltet sind, daß die Übertragung einer Drehbewegung von Behälter zu Behälter, aber auch eine Trennung der Behälter voneinander in Richtung der Rohrachse möglich ist.

2. Vorrichtung nach Anspruch 1, gekennzeichnet durch folgende Merkmale:
das Rohr (5) weist an seiner Innenwand in Rohrlängsrichtung verlaufende Führungszüge (15) auf, in die an den Behältern (11) angebrachte Gleiter (14) eingreifen;
die Hülse (6) ist eine Gewindehülse (6), längs deren Innenwand zumindest ein Gewindezug (16) verläuft, in den die Gleiter (14) der Behälter (11) eingreifen können.

3. Vorrichtung nach Anspruch 2, dadurch gekennzeichnet, daß die Führungszüge (15) im Drehrohr (5) und die Gewindezüge (16) in der Drehhülse (6) Nuten und die Gleiter (14) an den Behältern (11) in die Nuten (15, 16) eingreifende Nasen (14) sind.

4. Vorrichtung nach einem der vorhergehenden Ansprüche, dadurch gekennzeichnet, daß die Kupplungen (13) an den Behältern (11) als Stirnverzahnung aus abwechselnd höher bzw. niedriger gelegenen sektorförmigen Elementen ausgebildet sind.

5. Vorrichtung nach einem der vorhergehenden Ansprüche, dadurch gekennzeichnet, daß die Hülse (6) lediglich an ihrem Boden abgestützt ist.

6. Vorrichtung nach einem der vorhergehenden Ansprüche, dadurch gekennzeichnet, daß das Drehrohr (5) und die Hülse (6) in einem Durchgangsrohr (4) durch den Schwerwassertank (2) eines Reaktors angeordnet sind.

7. Vorrichtung nach einem der vorhergehenden Ansprüche, dadurch gekennzeichnet, daß im Anschluß an die Hülse (6) eine Vorrichtung (19) zum Übernehmen und Weitertransport der aus der Gewindehülse (6) austretenden Behälter vorgesehen ist.

## Claims

1. Device consisting of a transport system and associated containers to transport the containers within and along a substantially vertically disposed tube with simultaneous rotation of the containers about the tube axis, in particular to transport containers receiving semi-conductor single crystals through reactor wells in order to dope the single crystals, characterised by the following features:
the tube (5) can be rotated about its tube axis (rotational tube 5);
between the tube (5) and the containers (11) guide devices (14, 15) are provided which hold the containers (11) during transport along the rotational tube (5) in a rotationally fixed manner with respect to the latter;
directly adjoining the rotational tube (5), at the end of the transport path, a sleeve (6) is provided which is not connected to the rotational tube (5) but is held coaxially thereto in a rotationally fixed manner and is open at both ends;
between the sleeve (6) and the containers (11) a threaded device (14, 16) is provided, by means of which the containers (11) are transported along the sleeve (6);
the containers (11) comprise respective couplings (13) on their upper and lower ends, which, during transport of a series of adjoining containers (11), engage the couplings of the previous and subsequent container, wherein the couplings (13) are formed in such a way that the transfer of a rotational movement from container to container but also a separation of the containers from each other in the direction of the tube axis are possible.

2. Device according to claim 1, characterised by the following features:
on its inner wall the tube (5) comprises guide grooves (15) extending in the longitudinal direction of the tube, which are engaged by glide surfaces (14) attached to the containers (11);
the sleeve (6) is a threaded sleeve (6), along the inner wall of which extends at least one threaded groove (16), which can be engaged by the glide surfaces (14) of the containers (11).

3. Device according to claim 2, characterised in that the guide grooves (15) in the rotational tube (5) and the threaded grooves (16) in the rotational sleeve (6) are recesses and the glide surfaces (14) on the containers (11) are projections (14) engaging the recesses (15, 16).

4. Device according to any of the preceding claims, characterised in that the couplings (13) on the containers (11) are formed as end face toothing of alternately higher and lower positioned segment-shaped elements.

5. Device according to any of the preceding claims, characterised in that the sleeve (6) is supported only at its base.

6. Device according to any of the preceding claims characterised in that the rotational tube (5) and the sleeve (6) are disposed in a through tube (4) through the heavy water tank (2) of a reactor.

7. Device according to any of the preceding claims, characterised in that, subsequent to the sleeve (6), a device (19) is provided to take over and further transport the containers exiting from the threaded sleeve (6).

## Revendications

1. Dispositif comprenant un système de transport de réceptacles pour transporter les réceptacles à l'intérieur et le long d'un tube disposé essentiellement verticalement tandis que les réceptacles tournent autour de l'axe du tube, en particulier pour transporter des réceptacles de cristaux de semiconducteur à travers une cuve de réacteur pour doper les cristaux individuels, caractérisé en ce que :
le tube (5) peut tourner autour de son axe (tube rotatif 5) ;
entre le tube (5) et les réceptacles (11) sont prévus des dispositifs de guidage (14, 15) qui maintiennent les réceptables (11) fixes en rotation par rapport au tube rotatif (5) pendant leur transport le long de celui-ci ;
un manchon (6) ouvert aux deux extrémités, non relié au tube rotatif (5), prolonge directement le tube rotatif (5) à la fin de la zone de transport et est coaxial à celui-ci et bloqué en rotation ;
un dispositif à vis (14, 16) est disposé entre le manchon (6) et les réceptacles (11), et sert à transporter les réceptacles (11) le long du manchon (6) ;
les réceptacles (11) sont munis à leur parties supérieure et inférieure d'éléments de couplage (13) qui coopèrent avec les éléments de couplage des réceptacles précédent et suivant lors du transport de plusieurs réceptacles (11) l'un derrière l'autre, les éléments de couplage (13) ayant une configuration propre à permettre la transmission d'un mouvement de rotation d'un réceptacle à l'autre, mais aussi la séparation des réceptacles l'un de l'autre dans la direction de l'axe du tube.

2. Dispositif selon la revendication 1, caractérisé en ce que :
le tube (5) est muni au niveau de sa paroi intérieure d'éléments de guidage (15) longitudinaux au tube, qui coopèrent avec des éléments de guidage (14) des réceptacles (11) ;
le manchon (6) est un manchon à vis (6) dont la paroi intérieure est munie d'au moins un filetage (16) qui coopère avec les éléments de guidage (14) des réceptacles (11).

3. Dispositif selon la revendication 2, caractérisé en ce que les éléments de guidage (15) du tube rotatif (5) et le filetage (16) du manchon rotatif (6) sont des rainures, et les éléments de guidage (14) des réceptables (11) sont des tétons (14) pénétrant dans les rainures (15, 16).

4. Dispositif selon l'une quelconque des revendications précédentes, caractérisé en ce que les éléments de couplage (13) des réceptacles (11) sont des dentelures en étoile formées d'éléments en forme de secteurs alternativement en saillie et en retrait.

5. Dispositif selon l'une quelconque des revendications précédentes, caractérisé en ce que le manchon (6) est seulement maintenu à sa partie inférieure.

6. Dispositif selon l'une quelconque des revendications précédentes, caractérisé en ce que le tube rotatif (5) et le manchon (6) sont disposés dans un tube de passage (4) à travers le réservoir d'eau lourde (2) d'un réacteur.

7. Dispositif selon l'une quelconque des revendications précédentes, caractérisé en ce qu'un dispositif (19) est prévu à la sortie du manchon (6) pour recevoir et transporter des réceptacles sortant du manchon à vis (6).
